**Europäisches Patentamt**

**European Patent Office**

**Office européen des brevets**

(19)

(11) Veröffentlichungsnummer: **0 019 886**
**A1**

(12) # EUROPÄISCHE PATENTANMELDUNG

(21) Anmeldenummer: **80102900.0**

(22) Anmeldetag: **23.05.80**

(51) Int. Cl.³: **H 01 L 27/08,** G 11 C 11/34

(30) Priorität: **30.05.79 DE 2921993**

(43) Veröffentlichungstag der Anmeldung: **10.12.80**
**Patentblatt 80/25**

(84) Benannte Vertragsstaaten: **FR GB**

(71) Anmelder: **SIEMENS AKTIENGESELLSCHAFT Berlin und München, Postfach 22 02 61, D-8000 München 22 (DE)**

(72) Erfinder: **Scholtens, Jacobus W., Dipl.-Ing., Ortlindestrasse 2/06, D-8000 München 81 (DE)**
Erfinder: **Plasa, Gunther, Dipl.-Phys., Sommerlandstrasse 5, D-8214 Bernau (DE)**

(54) **Halbleiterspeicher.**

(57) Der Erfindung liegt die Aufgabe zugrunde, einen Halbleiterspeicher anzugeben, der mit der zugehörigen Randelektronik auf einem Siliciumchip aufgebracht ist, bei dem die Bildung von parasitären Halbleiterbauelementen verhindert wird, der mit möglichst kleinen Schreib- und Löschspannungen arbeitet, bei dem das Umprogrammieren mit Spannungen einer Polarität möglich ist, dessen Technologie weitgehend aus der 5-Volt-n-Kanal Silicium-Gate-Technologie abgeleitet werden kann, bei dem zugleich Enhancement- und Depletiontransistoren nebeneinander möglich sind, bei dem die Zellstrukturen einen minimalen Flächenbedarf aufweisen und bei dem die so hergestellte Schaltung CMOS und TTL kompatibel ist.

Erfindungsgemäß besteht der Halbleiterspeicher aus MOS Feldeffekttransistoren, die als integrierte Schaltung auf einem Siliciumchip so aufgebracht sind, daß auf dem gleichen Chip sowohl die Speichermatrix als auch die zugehörige Randelektronik untergebracht ist, wobei auf einem n-dotierten Siliciumsubstrat ein weiteres p-dotiertes Siliciumsubstrat epitaktisch aufgebracht wird und wobei in das epitaktisch aufgebrachte p-dotierte Siliciumsubstrat Speichertransistoren mit variablem Schwellwert einerseits und Logiktransistoren andererseits so eingebracht sind, daß das Substrat der Speichertransistoren von demjenigen der Logiktransistoren durch eine $n^+$-dotierte Zone, den Isolationsring, so getrennt wird, daß durch den Isolationsring das gesamte epitaktisch aufgebrachte p-dotierte Substrat bis hin zum n-dotierten Siliciumsubstrat durchsetzt wird, daß schmale, oberflächennahe $p^+$-dotierte Gebiete in das p-dotierte Siliciumsubstrat eingebracht sind, von denen die einen als sogenannte Channelstopper fungieren, während die anderen aus dem Isolationsring heraus in denjenigen Substratteil hineinragen, der mit Speichertransistoren bestückt ist, daß Oberflächenkontakte vorhanden sind, die den Isolationsring und die anderen schmalen, oberflächennahen $p^+$-dotierten Gebiete verbinden, daß weiterhin mittels Feldimplantation Dotierungen verschiedener Stärke unter den zwischen verschiedenen Speicherzellen befindlichen Feldbereichen im Halbleitermaterial angebracht sind, so daß die Bildung von parasitären Halbleiterbauelementen geschwächt oder verhindert wird, daß als Gate-Isolator bei den Speichertransistoren ein Isolator, bestehend aus einer Schichtenfolge von Siliciumoxid, Siliciumnitrid und Siliciumoxid verwendet wird, daß als Material für die Speicher-Gates Polysilicium verwendet wird und daß die Speichertransistoren eine Split-Gate-Struktur besitzen.

Anwendung zur Herstellung von nichtflüchtigen Speichern.

SIEMENS AKTIENGESELLSCHAFT          Unser Zeichen:
Berlin und München                  VPA 79 P 1 0 8 7 EUR

Halbleiterspeicher.

Die Erfindung betrifft einen Halbleiterspeicher, bestehend aus MOS Feldeffekttransistoren, die als integrierte Schaltung auf einem Siliciumchip so aufgebracht sind, daß auf dem gleichen Chip sowohl die Speichermatrix als auch die zugehörige Randelelektronik untergebracht ist, wobei auf einem n-dotierten Siliciumsubstrat ein weiteres p-dotiertes Siliciumsubstrat epitaktisch aufgebracht wird und wobei in das epitaktisch aufgebrachte p-dotierte Siliciumsubstrat Speichertransistoren mit variablem Schwellwert einerseits und Logiktransistoren andererseits so eingebracht sind, daß das Substrat der Speichertransistoren von demjenigen der Logiktransistoren durch eine $n^+$-dotierte Zone, den Isolationsring, so getrennt wird, daß durch den Isolationsring das gesamte epitaktisch aufgebrachte p-dotierte Substrat bis hin zum n-dotierten Siliciumsubstrat durchsetzt wird.

Kus 1 Lau - 8.5.79

Aus der DE-OS 26 27 827 ist eine monolytisch integrierte Halbleiterschaltung bekannt, bei der auf einem n-leitenden Halbleiterchip eine p-leitende Halbleiterschicht epitaktisch aufgebracht ist und wobei diese p-leitende Halbleiterschicht in zwei elektrisch voneinander isolierte Bereiche dadurch aufgeteilt ist, daß zwischen den beiden p-leitenden Bereichen ein $n^+$-leitender Bereich so angebracht ist, daß er die gesamte p-leitende Schicht bis hin zum n-leitenden Trägersubstrat durchsetzt. In einer der voneinander elektrisch isolierten p-leitenden Zonen ist eine Anzahl von n-Kanalfeldeffekttransistoren mit festem Schwellwert eingebracht, wobei jeder Feldeffekttransistor ein Gate-Dielektrikum besitzt, das aus aufeinanderfolgenden Schichten von 45 nm bis 55 nm dickem Siliciumoxid und 55 nm bis 62,5 nm dicken Siliciumnitrid besteht, während in dem zweiten elektrisch isolierten p-leitenden Bereich n-Kanalfeldeffekttransistoren mit variablem Schwellwert eingebracht sind, wobei jeder Feldeffekttransistor mit variablem Schwellwert ein Gate-Dielektrikum, bestehend aus aufeinanderfolgenden Schichten von 3,1 nm bis 3,4 nm dicken, thermisch aufgewachsenen Siliciumoxidschichten und etwa 55 nm bis 62,5 nm dicken Siliciumnitrid,besitzt. Das Felddielektrikum in jeder der beiden voneinander elektrisch isolierten Halbleiterzonen besteht aus aufeinanderfolgenden Schichten von 2,5 nm bis 4,0 nm dickem, aufgewachsenen Siliciumoxid, ca. 10 bis 20 nm dicken Aluminiumoxid und ca. 700 nm bis 800 nm dickem Siliciumoxid. Als Gatematerial wird Aluminium verwendet.

Das Aufbringen von Aluminiumoxidschichten auf Halbleiteroberflächen ist jedoch kein unproblematischer Teilprozeß, da sich nachfolgende Prozeßschritte technisch nicht problemlos durchführen lassen. Außerdem führen Temperaturbelastungen im weiteren Herstellungsprozeß zu Risiken für die Stabilität der hiernach gefertigten Bau-

0019886

elemente.

Bei Verwendung von Aluminium-Gates läßt sich keine selbstjustierende Wirkung zur Herstellung von Feldeffekttransistoren erzielen. Den Vorteil einer Selbstjustierung erreicht man hingegen bei Verwendung von Polysilicium als
Gate-Material. Die Selbstjustierung erbringt den bedeutenden Vorteil einer entsprechend höheren Packungsdichte von
Bauelementen in einem Halbleiterchip und bewirkt aufgrund der dadurch erzielten geringeren Überlappungskapazitäten eine entsprechende Erhöhung der Arbeitsgeschwindigkeit von hiernach gefertigten Schaltungen.

Außerdem ist bei Verwendung von Aluminium-Gates für Speichertransistoren die Ladungsträgerinjektion aus der Gate-
Elektrode in den Gate-Isolator des Speichertransistors
stärker als das der Fall ist bei der Verwendung von Polysilicium-Gates. Eine derartige Ladungsträgerinjektion
verschlechtert aber deutlich das Löschverhalten eines
solchen Transistors.

Es ist erstrebenswert, eine monolithisch integrierte
Halbleiterschaltung, wie sie eingangs beschrieben wurde,
so herzustellen, daß die Aluminium-Gates durch Polysilicium-Gates ersetzt werden. Polysilicium-Gates bringen nämlich neben anderen Vorteilen infolge der Eigenschaft, selbstjustierend zu wirken, den Vorteil einer
erheblichen Herstellungsvereinfachung und somit eine
bessere Wirtschaftlichkeit.

Das Aufbringen von Polysilicium-Gates auf eine Oxid-
Nitrid-Speicherisolatorschicht hat jedoch wegen der
Eigenleitfähigkeit von Siliciumnitrid den Nachteil, daß
beim Löschen mit Spannungen, die mindestens 25 V betragen oder größer sind, Ladungsträger vom Polysilicium- Gate ins Nitrid injiziert werden, wodurch der Löschvorgang negativ beeinflußt wird.

Aufgabe der vorliegenden Erfindung ist es, einen Halbleiterspeicher anzugeben, der mit der zugehörigen Randelektronik auf einem Siliciumchip aufgebracht ist, bei dem die Bildung von parasitären Halbleiterbauelementen verhindert wird, der mit möglichst kleinen Schreib- und Löschspannungen arbeitet, bei dem das Umprogrammieren mit Spannungen einer Polarität möglich ist, dessen Technologie weitgehend aus der 5 Volt- n-Kanal Silicium-Gate-Technologie abgeleitet werden kann, bei dem zugleich Enhancement- und Depletiontransistoren nebeneinander möglich sind, bei dem die Zellstrukturen einen minimalen Flächenbedarf aufweisen und bei dem die so hergestellte Schaltung CMOS und TTL kompatibel ist.

Diese Aufgabe wird für einen Halbleiterspeicher, bestehend aus MOS Feldeffekttransistoren, die als integrierte Schaltung auf einem Siliciumchip so aufgebracht sind, daß auf dem gleichen Chip sowohl die Speichermatrix als auch die zugehörige Randelektronik untergebracht ist, wobei auf einem n-dotierten Siliciumsubstrat ein weiteres p-dotiertes Siliciumsubstrat epitaktisch aufgebracht wird und wobei in das epitaktisch aufgebrachte p-dotierte Siliciumsubstrat Speichertransistoren mit variablem Schwellwert einerseits und Logiktransistoren andererseits so eingebracht sind, daß das Substrat der Speichertransistoren von demjenigen der Logiktransistoren durch eine $n^+$-dotierte Zone, den Isolationsring, so getrennt wird, daß durch den Isolationsring das gesamte epitaktisch aufgebrachte p-dotierte Substrat bis hin zum n-dotierten Siliciumsubstrat durchsetzt wird, dadurch gelöst, daß schmale, oberflächennahe $p^+$-dotierte Gebiete in das p-dotierte Siliciumsubstrat eingebracht sind, von denen die einen als sogenannte Channelstopper fungieren, während die anderen aus dem Isolationsring heraus in denjenigen Substratteil hineinragen, der mit Speichertransistoren bestückt ist und daß Oberflächenkontakte vorhanden sind, die den Isolationsring und die anderen schmalen, oberflächennahen, $p^+$-dotierten Gebiete verbinden, daß weiterhin mittels Feldimplantation Dotierungen verschiedener Stärke unter den zwischen verschiedenen Speicherzellen befindlichen Feldbereichen im Halbleitermaterial angebracht sind, so daß die Bildung von parasitären Halbleiterbauelementen geschwächt oder verhindert wird, daß als Gate-Isolator bei den Speichertransistoren ein Isolator, bestehend aus einer Schichtenfolge von Siliciumoxid, Siliciumnitrid und Siliciumoxid verwendet wird, daß als Material für die Speicher-Gates Polysilicium verwendet wird, und daß die Speichertransistoren eine Split-Gate-Struktur besitzen.

Das Anbringen der $p^+$-dotierten, oberflächennahen Gebiete, die aus dem Isolationsring heraus in das Speichersubstrat hineinragen, und die an der Halbleiteroberfläche mit Metallkontakten versehen sind, hat den Vorteil, daß zum Löschen der Speichertransistoren entweder eine positive Spannung an die zuvor genannten Metallkontakte angelegt werden kann, die über die $p^+$-dotierten Gebiete am p-dotierten, epitaktisch aufgebrachten Siliciumsubstrat anliegt, oder aber daß zum Löschen eine positive Spannung am n-dotierten Siliciumsubstrat engelegt wird, die über den $n^+$-dotierten Isolationsring die Metallkontakte und die $p^+$-dotierten oberflächennahen Gebiete an das p-dotierte epitaktisch aufgebrachte Speichersubstrat gelangt. In beiden Fällen kann damit der erfindungsgemäße Speicher durch bloßes Umschalten der Schreibspannung gelöscht werden.

Ein Löschvorgang, wie er mit erfindungsgemäßen Speichern möglich ist, bietet den Vorteil, daß die Problematik des Avalanche-Punch-through-Löschens umgangen wird, da bei erfindungsgemäßen Speichern mit geringeren Löschspannungen gearbeitet wird. Damit lassen sich auch parasitäre Kanaleinsätze unproblematisch verhindern.

Die Verhinderung von parasitären Kanaleinsätzen wird durch die folgenden zwei Maßnahmen gewährleistet:

1. Eine schwache Feldimplantation wird ganzflächig über eine Halbleiterscheibe ohne Maske angebracht. Sie wird bezüglich Dotierung und Energie so gewählt, daß die Spannungsfestigkeit der Treiberstufen in der Steuerlogik nicht gefährdet wird. Um dennoch einen ausreichend hohen Schwellwert für den parasitären Kanaleinsatz zu erreichen, werden zusätzlich die schmalen, oberflächennahen $p^+$-dotierten Gebiete als Channelstopper eingesetzt.

2. Im Gebiet der peripheren Randelektronik wird eine starke Feldimplantation eingebracht, da hier die Anforderung an die Spannungsfestigkeit mit ca. 15 Volt prinzipiell geringer ist als bei den Treiberstufen. Dennoch wird für parasitäre Transistoren ein ausreichend hoher Schwellwert von mindestens 20 Volt erreicht.

Außerdem ermöglichen die zusätzlichen $p^+$-dotierten Gebiete den Einsatz von $p^+/n^+$-Dioden, welche sowohl in der Eingangsschutzstruktur als auch, ähnlich wie Spannungsteiler, zur Erzeugung mehrerer Arbeitsspannungen benutzt werden können.

Schließlich hat die Anbringung einer zusätzlichen Silicium-Oxidschicht auf der Silicium-Nitrid-Schicht als Gate-Isolator der Speichertransistoren den Vorteil, daß eine Gate-Injektion verhindert wird.

Die Verwendung von Polysilicium als Speicher-Gate vereinfacht den Herstellungsprozeß hiermit gefertigter
Speicher wesentlich, da Polysilicium bezüglich der
Drain- und Sourcegebiete selbstjustierend wirkt. Dadurch wird das erfindungsgemäße Herstellungsverfahren
technologisch kompatibel zu üblichen n-Kanal-Polysilicium-Gate-Prozessen.

Der Vorteil einer Split-Gate-Struktur bei Speichertransistoren liegt in einem störungsfreien Lesen der eingeschriebenen Information. Der durch diese Struktur zusätzlich in Serie befindliche MOS-Transistoranteil verhindert, daß bei einer Überlöschung Speicherzellen in
den Depletionszustand geraten und der Lesevorgang verfälscht wird sowie gategesteuerte Durchbrüche zum Substrat entstehen.

Es ist auch vorteilhaft, daß ein erfindungsgemäßer
Halbleiterspeicher nach dem erfindungsgemäßen Verfahren hergestellt wird, das folgende Verfahrensschritte
nacheinander aufweist:

Auf dem n-dotierten Siliciumsubstrat wird das p-dotierte Siliciumsubstrat epitaktisch aufgebracht. Mittels
einer ersten Fototechnik und einer ersten Diffusion mit
geeigneten Dotierstoffen wird der $n^+$-dotierte Isolationsring in das p-dotierte epitaktisch aufgebrachte
Substrat so eingebracht, daß er die gesamte Schichtdicke des p-dotierten Substrats durchsetzt und bis in
das n-dotierte Siliciumsubstrat hineinreicht. Durch
eine zweite Fototechnik und eine erste Implantation
werden schmale oberflächennahe $p^+$-dotierte Gebiete in
das p-dotierte epitaktisch aufgebrachte Substrat eingebracht, von denen die einen als sogenannte Channelstopper fungieren, während die anderen vom Inneren des
Isolationsringes in denjenigen Teil des p-dotierten epitaktisch aufgebrachten Substrats hineinreichen, in den die Speichertransistoren später eingebracht werden.

Anschließend werden alle von Implantations- oder Dotiermasken herrührenden Schichten von der Oberfläche des p-dotierten, epitaktisch aufgebrachten Siliciumsubstrats entfernt. Auf der epitaktisch aufgebrachten p-dotierten Substratoberfläche wachsen zunächst eine erste Siliciumoxidschicht und auf dieser Schicht wiederum eine erste Siliciumnitridschicht auf. Mittels einer dritten Fototechnik und nachfolgendem Ätzen werden an denjenigen Teilen des Chips, an denen Dickoxidschichten aufwachsen sollen, sowohl die erste Siliciumnitrid- wie auch die erste Siliciumoxidschicht entfernt. Es erfolgt eine ganzflächige schwache zweite Implantation. Nach der vierten Fototechnik, die nur gewisse Bereiche innerhalb des später aufzuwachsenden Dickoxids freiläßt, erfolgt eine stärkere, dritte Implantation.

Nach Entferner der Lackmaske erfolgt durch geeignetes Erwärmen ein Eindiffundieren der durch die Feldimplantationen eingebrachten Ladungsträger in das Halbleitermaterial. Es erfolgt durch geeignete Oxidation die Bildung von Dickoxid an den freigelegten Halbleiteroberflächenteilen, während auf den Teilen des Siliciumnitrids nur ein sehr dünnes Oxid aufwächst. Anschließend wird mit Ausnahme der Dickoxidschicht die erste Siliciumoxidschicht und die erste Siliciumnitridschicht vom Halbleiterchip entfernt. Danach erfolgt die Herstellung einer zweiten Siliciumoxidschicht, der dünnen Tunneloxidschicht, ganzflächig auf dem Halbleiterchip und unmittelbar anschließend daran eine ganzflächige Abscheidung einer zweiten Siliciumnitridschicht. Anschließend erfolgt eine fünfte Fototechnik, bei welcher die zweite Siliciumoxid- und die zweite Siliciumnitridschicht nur an den Stellen erhalten bleiben, an denen Gates von Speichertransistoren vorgesehen sind, sowie im Bereich des Isolationsringes.

Mit der Lackmaske der fünften Fototechnik erfolgt anschließend eine vierte Implantation, die Enhancementimplantation der Transistoren des Logikteils. Anschließend wird diese Lackmaske abgelöst und die Scheibe wird neu belackt. Es erfolgt eine sechste Fototechnik, um im Logikteil des Substrats eine fünfte Implantation zur Einstellung von Depletions-Transistoren auszuführen. Nach erneuter Lackablösung und Reinigung erfolgt eine ganzflächige Abscheidung der dritten Siliciumoxidschicht auf der Substratoberfläche, wobei Gate-Oxidschichten an allen nitridfreien Chipoberflächenteilen entstehen, während eine dünne Oxidschicht, das sogenannte Oxinitrid, an nitridbehafteten Substratoberflächenteilen entsteht. Anschließend erfolgt eine siebente Fototechnik für Buried-Kontakte, bei der das Oxid bis zur Substratoberfläche an den Stellen der gewünschten Kontakte weggeätzt wird. Es erfolgt eine ganzflächige erste Polysiliciumbeschichtung. Es erfolgt die Abscheidung einer vierten Siliciumoxidschicht auf der Substratoberfläche zur Herstellung des Maskieroxids.

Eine achte Fototechnik ätzt Maskieroxid, Polysilicium und Siliciumoxid an denjenigen Stellen weg, an denen das Substrat zur Bildung von Diffusionsgebieten dotiert werden soll. Anschließend erfolgt eine zweite Diffusion mit geeignetem Dotierstoff, der in dem p-dotierten epitaktisch abgeschiedenen Siliciumsubstrag $n^+$-dotierte Bereiche hervorruft, während das Polysilicium infolge des Maskieroxids nur schwach dotiert wird.

Es erfolgt eine neunte Fototechnik, bei der nur einzelne Kontaktlöcher im Bereich des Isolationsringes von Oxid und Polysilicium freigeätzt werden, während die darunter befindliche Nitridschicht erhalten bleibt. Anschließend erfolgt eine pyrolytische Abscheidung einer fünften Siliciumoxidschicht. Daran anschließend erfolgt mit einer zehnten Fototechnik abermals ein Kontaktlochätzen zur Herstellung von metallischen Kontakten, z.B. zum Gate, Source, Drain.

Anschließend an die zehnte Fototechnik erfolgt ein Verdichten des durch Pyrolyse abgeschiedenen fünften Oxids, d.h. ein Erwärmen des Oxids, so daß scharfe Kanten und Risse im Oxid beseitigt werden.

Es folgt eine ganzflächige Überätzung der Scheiben, um die Kontaktlöcher von der bei dem Verdichten entstandenen dünnen Oxidschicht zu befreien. Durch eine daran anschließende ebenfalls ganzflächige Überätzung mit einer selektiv wirkenden Nitridätzlösung wird das von der zweiten Nitridabscheidung stammende Nitrid aus den Kontaktlöchern des Isolationsringes entfernt. Schließlich erfolgt eine Abscheidung von Metall, das durch eine elfte Fototechnik für den Anschluß der vorher freigeätzten Kontaktlöcher und die Verdrahtung strukturiert wird. In die anschließend abgeschiedene Passivierungsschicht zum Schutz der Systemoberfläche werden in einer zwölften Fototechnik Fenster für die äußeren Chipanschlüsse geätzt.

Das erfindungsgemäße Verfahren hat den Vorteil einer guten Wirtschaftlichkeit, insbesondere als zu einem großen Teil die bereits entwickelte Technologie der 5 Volt-n-Kanal Polysilicium-Gate-Technologie zur Anwendung kommt und da außerdem nur eine zusätzliche Maske für die Strukturierung der Speicher-Gates benötigt wird. Mittels einer einzigen Oxidation wird gleichzeitig das

Gate-Oxid für die Logiktransistoren sowie die Oxinitridschicht der Speicher-Gates hergestellt, welche un-erwünschte Ladungsträgerinjektionen aus dem Polysili-cium-Gate in die Speichernitridschicht verhindert. Damit wird außerdem eine Photomaske zur Herstellung des Gate-Oxids für die Logiktransistoren eingespart.

Es ist auch vorteilhaft, daß als Dotierstoffe bei der ersten und zweiten Diffusion Phosphor oder ein anderes geeignetes Element der Gruppe V verwendet wird und daß die erste, zweite, dritte und vierte Implantation mit Bor oder einem anderen geeigneten Element der Gruppe III erfolgt.

Die genannten Stoffe zur Dotierung und Implantation haben sich bei der Herstellung von erfindungsgemäßen Halbleiterspeichern als besonders geeignet erwiesen.

Es ist auch vorteilhaft, daß die fünfte Implantation mit Arsen oder einem anderen geeigneten Element der Gruppe V erfolgt.

Diese Maßnahme hat für erfindungsgemäße Halbleiterspeicher den Vorteil, daß dadurch auf einfache Weise die Einstellung der Schwellspannungen der Enhancement- und Depletiontransistoren im Logikteil in einem weiten Bereich ermöglicht wird. Durch diese Möglichkeit der Anpassung von Schwellspannungen wird die elektrische Kompatibilität der nach dem erfindungsgemäßen Verfahren hergestellten Schaltungen zu bereits vorhandenen anderen Schaltweisen in n-Kanal-Polysilicium-Gate- oder CMOS- sowie TTL-Technik gewährleistet.

Weiterhin ist es vorteilhaft, daß die zweite Siliciumoxidschicht, die Tunneloxidschicht, eine Schichtdicke von 2 nm bis 4 nm, insbesondere eine Schichtdicke von 3 nm aufweist und daß die Schichtdicke der zweiten Siliciumnitridschicht 40 nm bis 60 nm, insbesondere 50 nm beträgt, und daß die dritte Siliciumoxidschicht eine Stärke von 70 nm bis 150 nm, insbesondere von 120 nm besitzt. Die genannten Schichtstärken der Speicherisolatorschichten gewährleisten sowohl die Anwendung von Schreibspannungen zwischen 25 V und 30 V als auch Lesespannungen zwischen 3 V und 8 V sowie Löschspannungen zwischen 25 V und 35 V. Gleichzeitig hat die Dimensionierung dieser Schichten den Vorteil, daß die Tunneloxidschicht einerseits dünn genug ist, andererseits noch so dick ist, daß sie mit Sicherheit reproduzierbar aufgebracht werden kann. Weiterhin haben diese Schichtstärken den Vorteil, daß sie ein sicheres Umprogrammieren mit gutem Langzeitverhalten verknüpfen.

Es ist auch vorteilhaft, daß die Buriedkontakte aus Polysilicium bestehen. Dieses Material hat sich für die Herstellung von erfindungsgemäßen Speichern als besonders geeignet erwiesen.

Schließlich ist es auch vorteilhaft, daß die Metallkontakte aus Aluminium, mit einem gewissen Anteil Silicium, bestehen. Die Verwendung dieses Metallgemisches hat sich wegen seiner einfachen Abscheidemöglichkeit, z.B. der Vakuumbedampfung und der damit möglichen guten Kontrolle des Siliciumanteils im Aluminium als besonders vorteilhaft erwiesen.

Durch die Verwendung von Aluminium mit einem gewissen Anteil Silicium anstelle von reinem Aluminium wird die Entstehung von Legierstrukturen in den Kontaktlöchern verhindert. Diese Legierstrukturen bewirken oftmals Kurzschlüsse an p/n-Übergängen. Bei der Verwendung von Aluminium mit einem Anteil an Silicium werden von Legierstrukturen herrührende Kurzschlüsse von vornherein vermieden.

Nachfolgend wird die Erfindung anhand der Zeichnung und an Ausführungsbeispielen näher erläutert. Es zeigen:

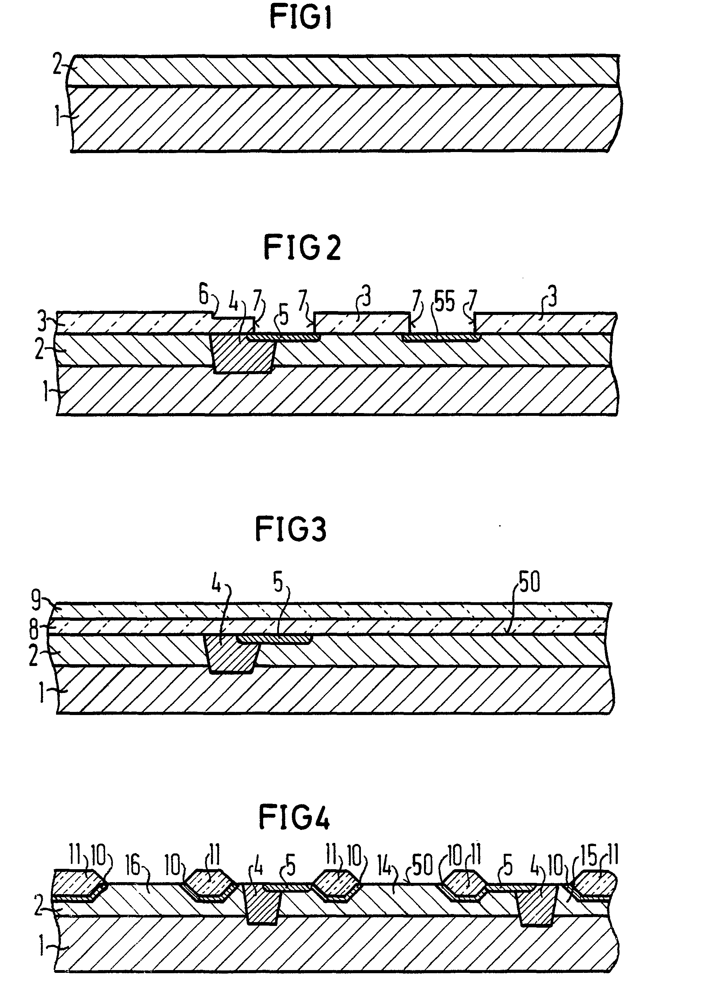

Die Figuren 1 bis 9 verschiedene Verfahrensschritte bei der Herstellung von erfindungsgemäßen Halbleiterspeichern.

In den Figuren 1 bis 9 werden identische Teile mit gleichen Ziffern oder Buchstaben bezeichnet, weshalb bereits beschriebene Figurenteile in nachfolgenden Figuren nicht nochmals beschrieben werden.

Fig. 1 zeigt im Querschnitt ein n-dotiertes Siliciumsubstrat 1 mit einem epitaktisch darauf aufgebrachten p-dotierten Siliciumsubstrat 2. Das n-Siliciumsubstrat 1, auch Muttersubstrat genannt, kann insbesondere eine Leitfähigkeit von $1\,\Omega\,cm$ bis $20\,\Omega\,cm$ und eine Kristallorientierung $<100>$ aufweisen. Die p-dotierte epitaktisch abgeschiedene Siliciumschicht 2 weist insbesondere eine Stärke von $8\,\mu m$ bis $12\,\mu m$, eine Leitfähigkeit von $20\,\Omega\,cm$ und ebenfalls eine Kristallorientierung $<100>$ auf.

Fig. 2 zeigt im Querschnitt ein Siliciumchip wie Fig.1, mit einer Siliciumdioxidschicht 3 auf der Oberfläche des p-dotierten Siliciumsubstrats 2, bei dem mittels einer ersten Fototechnik, angedeutet durch die Stufe 6 in der Siliciumdioxidschicht 3 und einer nachfolgenden Diffusion mit Dotierstoff ein $n^+$-dotierter Isolationsring 4 in die Siliciumsubstratschicht 2 so tief eindiffundiert ist, daß er noch Teile der Siliciumsubstratschicht 1 durchsetzt. Als Diffusionsmaterialien für die Dotierung des Isolationsringes kommen Phosphor oder ein anderes geeignetes Element der Gruppe V infrage. Eine nachfolgende zweite Fototechnik, angedeutet durch die Öffnungen 7 in der Siliciumdioxidschicht 3, wird anschließend durchgeführt, um mittels einer Implantation schmale oberflächennahe $p^+$-dotierte Gebiete 5 bzw. 55 herzustellen, wobei die Gebiete 5 vom Inneren des Isolationsringes 4 in denjenigen Teil des p-dotierten Siliciumsubstrates 2 hineinragen, in den später Speichertransistoren eingebracht werden. Weitere oberflächennahe $p^+$-dotierte Gebiete 55 sind zur späteren Erzeugung von sogenannten Channelstoppern angebracht. Die $p^+$-dotierten Gebiete 5 bzw. 55 können z.B. durch eine Implantation von Bor oder einem anderen Element der Gruppe III hergestellt werden.

Fig. 3 zeigt im Querschnitt denjenigen Teilbereich aus Fig.2, der einen $n^+$-dotierten Isolationsring 4 enthält. Nach Entfernen der Masken von Fig.2, insbesondere der Siliciumdioxidschicht 3 von Fig.2, wird in Fig.3 auf der Halbleiteroberfläche 50 zunächst eine insbesondere 100 nm starke Siliciumdioxidschicht 8 und darüber eine insbesondere 200 nm starke Siliciumnitridschicht 9 aufgetragen.

Fig. 4 stellt einen gegenüber den Fig. 2 und 3 anderen Teilbereich des erfindungsgemäßen Speicherchips im Querschnitt dar, nämlich einen solchen, der den gesamten Speicherbereich 14 neben Teilbereichen 15 und 16 der Randelektronik darstellt. Das p-dotierte Siliciumsubstrat 2 des Speicherbereichs 14 wird durch den Isolationsring 4 von den Teilbereichen 15 und 16 der Randelektronik elektrisch getrennt. Fig. 4 zeigt einen Verfahrensschritt, bei den mittels einer dritten Fototechnik und nachfolgendem Ätzen an denjenigen Teilen der Halbleiteroberfläche 50 die Siliciumnitridschicht 9 und die Siliciumoxidschicht 8 aus Fig. 3 entfernt wurden, an denen Siliciumdioxid aufwachsen soll. Danach erfolgt zunächst eine ganzflächige schwache zweite Feldimplantation. Nach einer weiteren Fototechnik, der vierten Fototechnik, die nur gewisse Bereiche innerhalb des später aufzuwachsenden Dickoxids freiläßt, erfolgt eine stärkere dritte Feldimplantation. Nach Entfernen der Lackmaske der vorhergehenden Fototechnik erfolgt durch geeignetes Erwärmen ein Eindiffundieren der durch die Feldimplantation eingebrachten Ladungsträger in das Halbleitermaterial. Danach erfolgt durch geeignete Oxidation mittels der sogenannten LOCOS-Technik die Bildung der Dickoxidbereiche 11. Die je nach den Erfordernissen schwach oder stark implantierten Bereiche 10 sind, wie die vorausgegangene Beschreibung des Herstellungsprozesses es zeigt, unter den Dickoxidbereichen 11 angeordnet. Bei Halbleiterteilen mit hoher anliegender Betriebsspannung sind schwach implantierte Bereiche 10 in Verbindung mit in Fig. 2 dargestellten Channelstoppern 55 angeordnet, während für Teile mit niedrigerer Betriebsspannung stärker implantierte Bereiche 10 vorgesehen sind. Anschließend an die Dickoxidbildung wird die Siliciumnitridschicht 9 und die Siliciumoxidschicht 8 von der Halbleiteroberfläche 50 entfernt.

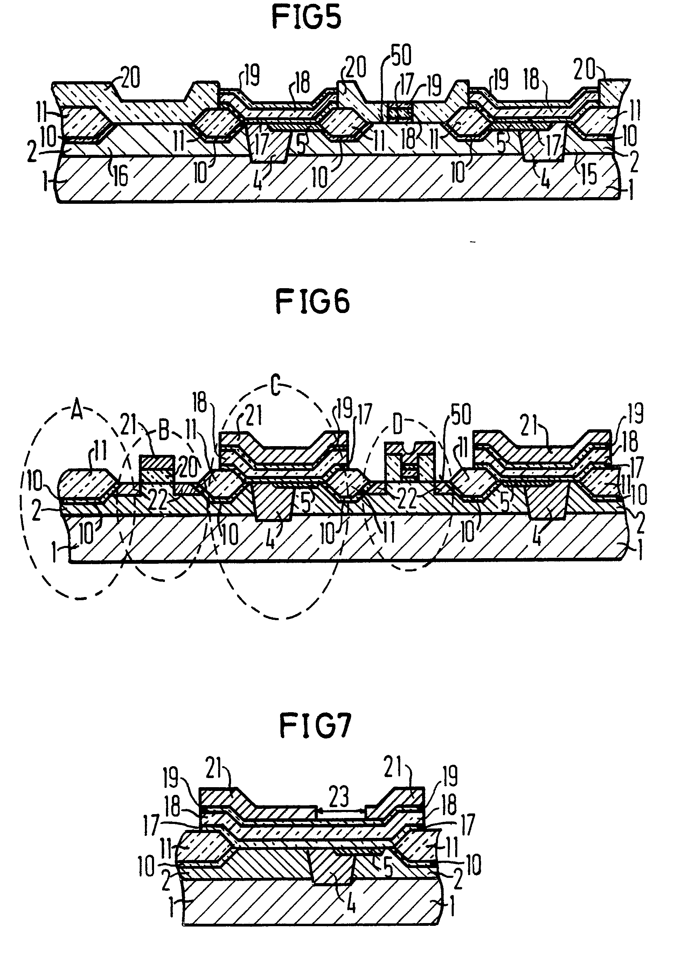

Fig. 5 zeigt den gleichen Teilbereich eines Halbleiterchips wie Fig. 4, bei dem auf der Halbleiteroberfläche 50 eine zweite Siliciumdioxidschicht 17 als dünne Tunneloxidschicht ganzflächig hergestellt wurde und unmittelbar daran anschließend eine zweite Siliciumnitridschicht 18 ganzflächig abgeschieden wurde.

Anschließend erfolgte eine fünfte Fototechnik, bei welcher die zweite Siliciumdioxidschicht 17 und die zweite Siliciumnitridschicht 18 nur in gewissen Bereichen um den Isolationsring 4 herum und an denjenigen Stellen erhalten bleiben, an denen Gates von Speichertransistoren vorgesehen sind. Mit der Lackmaske der fünften Fototechnik erfolgt anschließend eine vierte Implantation, die Enhancementimplantation. Bei dieser Implantation kann z.B. Bor oder ein anderes Element der Gruppe III als Implantationsstoff verwendet werden. Anschließend wird die Lackmaske abgelöst und der Chip neu belackt. Es erfolgt eine sechste Fototechnik, um im Logikteil, den Teilbereichen 15 und 16, Depletionstransistoren vorzubereiten. Als Dotierstoff kann hierzu z.B. Arsen oder ein anderes geeignetes Element der Gruppe V verwendet werden. Nach Lackablösung und Reinigung der Chipoberfläche erfolgt eine ganzflächige dritte Oxidation, die Gate-Oxidation, wobei auf denjenigen Chipoberflächenteilen, die mit der Siliciumnitridschicht 18 bedeckt sind, nur eine sehr dünne dritte Siliciumoxidschicht 19 aufwächst, während auf der übrigen Halbleiteroberfläche die dritte etwas dickere Siliciumoxidschicht 20 aufwächst.

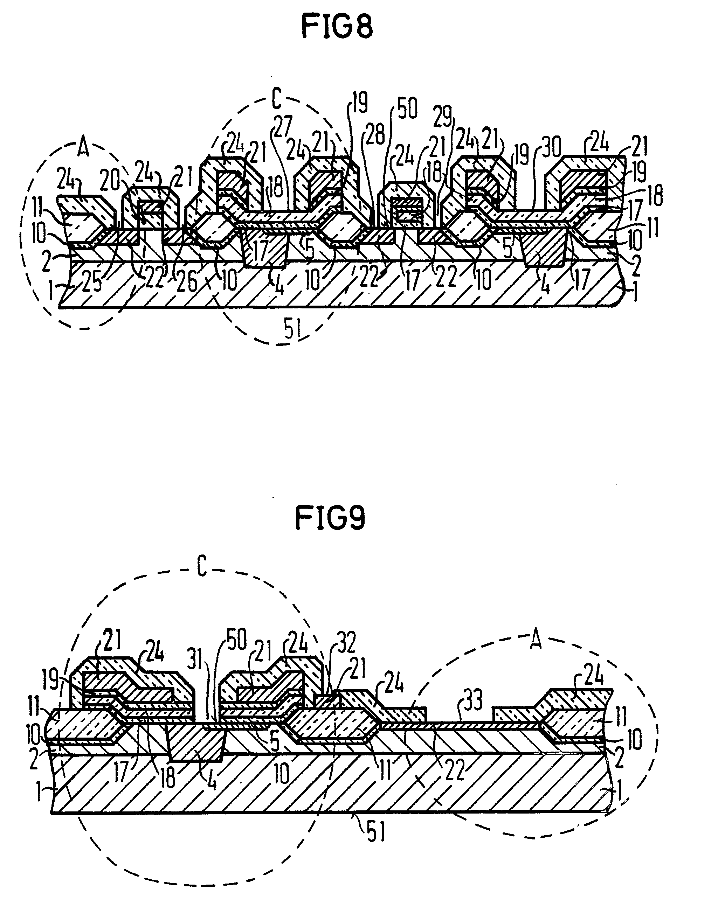

Fig. 6 zeigt den gleichen Teilbereich des Halbleiterchips wie Fig. 5, nachdem eine siebente Fototechnik zur Erzeugung von Buried-Kontakten erfolgte, bei der das Siliciumdioxid bis zur Substratoberfläche 50 an den Stellen der gewünschten Kontakte weggeätzt wurde. Anschließend erfolgte die Abscheidung einer ganzflächigen ersten Polysiliciumschicht 21 und eine vierte Oxidation des Polysiliciums mit Maskieroxid. Eine achte Fototechnik ätzt Maskieroxid, die Polysiliciumschicht 21 und die Siliciumdioxidschicht 20 an denjenigen Stellen weg, an denen die p-dotierte Siliciumsubstratschicht 2 zur Bildung von Drain- und Source-Gebieten dotiert werden soll. Anschließend erfolgt eine zweite Diffusion mit geeignetem Dotierstoff, z.B. Phosphor oder einem anderen geeigneten Element der Gruppe V, wobei in den freigelegten Teilen der p-dotierten, epitaktisch aufgebrachten Siliciumsubstratschicht 2, $n^+$-dotierte Bereiche 22 erzeugt werden, während die Polysiliciumschicht 21 infolge des Maskieroxids nur schwach dotiert wird. Nach dem beschriebenen Herstellungsprozeß bleiben schwach n-dotierte Polysiliciumschichten 21 auf einigen Chipoberflächenteilen zurück, wie in Fig.6 dargestellt. Andererseits entstehen in der p-dotierten Siliciumsubstratschicht 2, $n^+$-dotierte Bereiche 22, die im Teilbereich B aus Fig.6 Source- und Drain-Gebiete für Transistoren der Randelektronik und im Bereich D Source- und Drain-Gebiete für Speichertransistoren bilden. Der in Fig. 6 dargestellte Teilbereich A entspricht einem in Fig. 8 und 9 dargestellten Teilbereich A des erfindungsgemäßen Halbleiterspeichers. Der Teilbereich C der Fig. 6 wird in Fig. 7 und 8 nochmals dargestellt.

Fig. 7 stellt den Teilbereich C aus Fig.6 dar, bei dem durch eine neunte Fototechnik ein Kontaktloch 23 im Bereich eines Iaolationsringes 4 vom oberflächlich stets gebildeten Oxid und von der Polysiliciumschicht 21 freigeätzt wird.

Fig. 8 stellt den gleichen Ausschnitt aus dem erfindungsgemäßen Halbleiterspeicher wie Fig. 6 dar, bei dem an bestimmten Stellen Kontaktlöcher in die Polysiliciumschicht 21, wie in Fig. 7 dargestellt, eingeätzt wurden, und bei dem nach einer fünften Oxidation der Chipoberfläche und einer zehnten Fototechnik mit nachfolgendem Kontaktlochätzen auf der Chipoberfläche Teile einer Siliciumdioxidschicht 24 stehen bleiben, zwischen denen sich Kontaktlöcher 25, 26, 27, 28, 29 und 30 befinden. Die Siliciumdioxidschicht 24 wird anschließend verdichtet, d.h. sie wird erwärmt, so daß scharfe Kanten und Risse im Oxid vermieden werden. Nach nochmaligem Überätzen der Kontaktlöcher erfolgt eine ganzflächige Metallabscheidung, z.B. eine ganzflächige Aufdampfung eines Aluminium-Silizium-Gemisches, der wiederum eine elfte Fototechnik folgt, wodurch ein gewünschtes Muster von Kontakten und Leitbahnen auf der Chipoberfläche erzeugt wird. Nach weiteren Reinigungs- und Passivierungsmaßnahmen an der Chipoberfläche 50 erfolgt schließlich noch die Kontaktierung der rückseitigen Chipoberfläche 51, z.B. durch ganzflächige Aluminiumbedampfung in einer Stärke

von 1 /um.

Fig. 9 zeigt verschiedene Kontaktlöcher 31, 32, 33 auf einem erfindungsgemäßen Halbleiterchip, bevor eine Belegung dieser Kontaktlöcher mit einem Metall erfolgt. Der Bereich C von Fig.9 entspricht dabei dem Bereich C aus Fig.8 und Fig.6. Gegenüber dem Kontaktloch 27 aus Fig.8 ist im Kontaktloch 31 die Siliciumnitridschicht 18 und die Siliciumdioxidschicht 17 bis zur Halbleiteroberfläche 50 freigeätzt. Das Kontaktloch 32 sieht einen Metallkontakt vor, der über einer Polysiliciumschicht 21 und einer Dickoxidschicht 11 verläuft.

Der Bereich A aus Fig.9 entspricht seitenverkehrt dem Bereich A aus Fig.8 und Fig.6. Das Kontaktloch 33 sieht eine Metallkontaktierung von n$^+$-dotierten Bereichen 22 eines erfindungsgemäßen Halbleiterspeichers vor, z.B. als Source- oder Drainanschluß eines Transistors.

Mittels eines Metallkontaktes im Kontaktloch 31 und eines Metallkontaktes an der Rückseite der Halbleiteroberfläche 51 kann ein erfindungsgemäßer Speicher somit durch Anlegen einer geeigneten Spannung am Rückseitenkontakt über das n-Siliciumsubstrat 1, den Isolationsring 4, den Metallkontakt im Kontaktloch 31 und das p$^+$-dotierte Gebiet 5 hinweg am p-dotierten Siliciumsubstrat 2 gelöscht werden. Eine zweite Möglichkeit erfindungsgemäße Speicher zu löschen besteht darin, am Kontakt im Kontaktloch 31 eine entsprechende Spannung anzulegen, die über das p$^+$-dotierte Gebiet 5 an das p-dotierte Siliciumsubstrat 2 gelangt, so daß wiederum ein direktes Löschen der Speichertransistoren zum p-dotierten Siliciumsubstrat 2 möglich ist.

Durch die genannten Möglichkeiten erfindungsgemäße Speicher zu löschen, wird die Problematik des Avalanche-Punchthroug-Löschens ausgeschaltet. Ein Löschen ohne heiße Ladungsträger, wie das bei erfindungsgemäßen Halbleiterspeichern möglich ist, hat den Vorteil einer größeren Lebensdauer des Speichers. Es ergeben sich gleichzeitig eine erhöhte Zahl von Schreib-Lösch-Zyklen des Speichers, bei konstanten Lösch- und Schreibzeiten des Speichers. Weiterhin werden Oyidvergiftungen und die Entstehung von leitenden Kanälen im Speicheroxid vermieden.

Die Entstehung von parasitären Halbleiterbauelementen wird durch drei Maßnahmen verhindert. Einmal durch die schwache Feldimplantation unterhalb der Dickoxidbereiche, weiterhin durch die starke Feldimplantation unterhalb einzelner entsprechend vorgegebener Bereiche des Dickoxids und schließlich durch ein geeignetes Anbringen der Channelstopper 55. An den Stellen hoher anliegender Betriebsspannungen werden zur Vermeidung von parasitären Halbleiterbauelementen eine schwache Feldimplantation unterhalb der Dickoxidbereiche in Verbindung mit Channelstoppern angewendet. In Bereichen niedrigerer Betriebsspannung von erfindungsgemäßen Speichern wird zur Vermeidung parasitärer Halbleiterbauelemente eine starke Feldimplantetion unterhalb der Dickoxidbereiche angewendet und dafür auf Channelstopper verzichtet.

Mit dem erfindungsgemäßen Speicher läßt sich in vorteilhafter Weise die 5-Volt-n-Kanal-Si-Gate-Technologie für die Herstellung von erfindungsgemäßen Speichern anwenden.

Die zusätzliche $p^+$-Dotierung ermöglicht weiterhin den Einsatz von $p^+/n^+$-Dioden, welche sowohl in der Eingangsschutzstruktur als auch für die Erzeugung mehrerer Arbeitsspannungen als Spannungsteiler benutzt werden können.

Als weiterer Vorteil des beschriebenen Herstellungsverfahrens für erfindungsgemäße Speicher ist zu nennen, daß die Strukturierung des Speichergates nur eine zusätzliche Maske benötigt. Mit Hilfe einer zweiten Gateoxidation wird gleichzeitig das Gateoxid für die peripheren Strukturen sowie eine Oxinitridschicht auf den Speichergates gebildet, die unerwünschte Ladungsträgerinjektionen aus dem Polysiliciumgate in die Speichernitridschicht verhindert.

Die Speichertransistoren werden in einer Split-Gate-Struktur hergestellt. Eine solche Struktur verhindert das Depletionverhalten des Speichertransistors und schützt gegen gategesteuerte Durchbrüche zum Substrat.

Erfindungsgemäße Speicher eignen sich zur Herstellung von nichtflüchtigen Speichern.

9 Figuren
10 Patentansprüche

Patentansprüche

1. Halbleiterspeicher, bestehend aus MOS-Feldeffekttransistoren, die als integrierte Schaltung auf einem Siliciumchip so aufgebracht sind, daß auf dem gleichen Chip sowohl die Speichermatrix als auch die zugehörige Randelektronik untergebracht ist, wobei auf einem n-dotierten Siliciumsubstrat ein weiteres p-dotiertes Siliciumsubstrat epitaktisch aufgebracht wird und wobei in das epitaktisch aufgebrachte p-dotierte Siliciumsubstrat Speichertransistoren mit variablem Schwellwert einerseits und Logiktransistoren andererseits so eingebracht sind, daß das Substrat der Speichertransistoren von demjenigen der Logiktransistoren durch eine $n^+$-dotierte Zone, den Isolationsring, so getrennt wird, daß durch den Isolationsring das gesamte epitaktisch aufgebrachte p-dotierte Substrat bis hin zum n-dotierten Siliciumsubstrat durchsetzt wird, d a d u r c h   g e k e n n - z e i c h n e t , daß schmale, oberflächennahe $p^+$-dotierte Gebiet in das p-dotierte Siliciumsubstrat eingebracht sind, von denen die einen als sogenannte Channelstopper fungieren, während die anderen aus dem Isolationsring heraus in denjenigen Substratteil hineinragen, der mit Speichertransistoren bestückt ist,
daß Oberflächenkontakte vorhanden sind, die den Isolationsring und die anderen schmalen, oberflächennahen, $p^+$-dotierten Gebiete verbinden,
daß weiterhin mittels Feldimplantation Dotierungen verschiedener Stärke unter den zwischen verschiedenen Speicherzellen befindlichen Feldbereichen im Halbleitermaterial angebracht sind, so daß die Bildung von parasitären Halbleiterbauelementen geschwächt oder verhindert wird,
daß als Gate-Isolator bei den Speichertransistoren ein Isolator, bestehend aus einer Schichtenfolge von Siliciumoxid, Siliciumnitrid und Siliciumoxid verwendet
wird,

daß als Material für die Speicher-Gates Polysilicium
verwendet wird,

und daß die Speichertransistoren eine Split-Gate-Struktur besitzen.


2. Verfahren zur Herstellung des Halbleiterspeichers
nach Anspruch 1, d a d u r c h   g e k e n n z e i c h -
n e t , daß die folgenden Verfahrensschritte nacheinander vorgenommen werden:

Auf dem n-dotierten Siliciumsubstrat wird das p-dotierte Siliciumsubstrat epitaktisch aufgebracht.

Mittels einer ersten Fototechnik und einer ersten Diffusion mit geeigneten Dotierstoffen wird der $n^+$-dotierte
Isolationsring in das p-dotierte epitaktisch aufgebrachte Substrat so eingebracht, daß er die gesamte Schichtdicke des p-dotierten Substrats durchsetzt und bis in
das n-dotierte Siliciumsubstrat hineinreicht.

Durch eine zweite Fototechnik und eine erste Implantation
werden schmale oberflächennahe $p^+$-dotierte Gebiete in
das p-dotierte epitaktisch aufgebrachte Substrat eingebracht, von denen die einen als sogenannte Channelstopper fungieren, während die anderen vom Inneren des Isolationsringes in denjenigen Teil des p-dotierten epitaktisch aufgebrachten Substrats hineinreichen, in den die
Speichertransistoren später eingebracht werden.


Anschließend werden alle von Implantations- oder Dotiermasken herrührende Schichten von der Oberfläche des
p-dotierten, epitaktisch aufgebrachten Siliciumsubstrats
entfernt.

Auf der epitaktisch aufgebrachten p-dotierten Substratoberfläche wachsen zunächst eine erste Siliciumoxidschicht und auf dieser Schicht wiederum eine erste Siliciumnitridschicht auf.

Mittels einer dritten Fototechnik und nachfolgendem Ätzen werden an denjenigen Teilen des Chips, an denen Dickoxidschichten aufwachsen sollen, sowohl die erste Siliciumnitrid- wie auch die erste Siliciumoxidschicht entfernt.

Es erfolgt eine ganzflächige schwache zweite Implantation.

Nach der vierten Fototechnik, die nur gewisse Bereiche innerhalb des später aufzuwachsenden Dickoxids freiläßt, erfolgt eine stärkere, dritte Implantation.

Nach Entfernen der Lackmaske erfolgt durch geeignetes Erwärmen ein Eindiffundieren der durch die Feldimplantationen eingebrachten Ladungsträger in das Halbleitermaterial.

Es erfolgt durch geeignete Oxidation die Bildung von Dickoxid an den freigelegten Halbleiteroberflächenteilen, während auf den Teilen des Siliciumnitrids nur ein sehr dünnes Oxid aufwächst.

Anschließend wird mit Ausnahme der Dickoxidschicht die erste Siliciumoxidschicht und die erste Siliciumnitridschicht vom Halbleiterchip entfernt.

Danach erfolgt die Herstellung einer zweiten Siliciumoxidschicht, der dünnen Tunneloxidschicht, ganzflächig auf dem Halbleiterchip und unmittelbar anschließend daran eine ganzflächige Abscheidung einer zweiten Siliciumnitridschicht.

Anschließend erfolgt eine fünfte Fototechnik, bei welcher die zweite Siliciumoxid- und die zweite Siliciumnitridschicht nur an den Stellen erhalten bleiben, an denen Gates von Speichertransistoren vorgesehen sind, sowie im Bereich des Isolationsringes.

Mit der Lackmaske der fünften Fototechnik erfolgt anschließend eine vierte Implantation, die Enhancement-

0019886

-24 -     VPA 79 P 1087 EUR-

implantation, der Transistoren des Logikteils.
Anschließend wird diese Lackmaske abgelöst und die
Scheibe wird neu gelackt.

Es erfolgt eine sechste Fototechnik, im Logikteil des
Substrats eine fünfte Implantation zur Einstellung von
Depletion-Transistoren.

Nach erneuter Lackablösung und Reinigung erfolgt eine
ganzflächige Abscheidung der dritten Siliciumoxidschicht
auf der Substratoberfläche, wobei Gateoxid an allen nitridfreien Chipoberflächenteilen entsteht, während eine
dünne Oxidschicht, das sogenannte Oxinitrid, an nitridbehafteten Substratoberflächenteilen entsteht.

Anschließend erfolgt eine siebente Fototechnik für
Buried-Kontakte, bei der das Oxid bis zur Substratoberfläche an den Stellen der gewünschten Kontakte weggeätzt
wird.

Es erfolgt eine ganzflächige erste Polysiliciumbeschichtung.

Es erfolgt die Abscheidung einer vierten Siliciumoxidschicht auf der Substratoberfläche zur Herstellung des
Maskieroxids.

Eine achte Fototechnik ätzt Maskieroxid, Polysilicium
und Siliciumoxid an denjenigen Stellen weg, an denen die
Substratschicht zur Bildung von Diffusionsgebieten dotiert werden soll.

Anschließend erfolgt eine zweite Diffusion mit geeignetem Dotierstoff, der in dem p-dotierten epitaktisch abgeschiedenen Siliciumsubstrat $n^+$-dotierte Bereiche hervorruft, während das Polysilicium infolge des Maskieroxids nur schwach dotiert wird.

Es erfolgt eine neunte Fototechnik, bei der nur einzelne
Kontaktlöcher im Bereich des Isolationsringes von Oxid
und Polysilicium freigeätzt werden, während die darunter
befindliche Nitridschicht erhalten bleibt.

Anschließend erfolgt eine pyrolytische Abscheidung einer fünften Siliciumoxidschicht.

Daran anschließend erfolgt mit einer zehnten Fototechnik abermals ein Kontaktlochätzen zur Herstellung von metallischen Kontakten, z.B. zum Gate, Source, Drain.

Anschließend an die zehnte Fototechnik erfolgt ein Verdichten des durch Pyrolyse abgeschiedenen fünften Oxids, d.h. ein Erwärmen des Oxids, so daß scharfe Kanten und Risse im Oxid beseitigt werden.

Es folgt ein ganzflächige Überätzung der Scheiben, um die Kontaktlöcher von der bei dem Verdichten entstandenen dünnen Oxidschicht zu befreien.

Durch eine daran anschließende ebenfalls ganzflächige Überätzung mit einer selektiv wirkenden Nitridätzlösung wird das von der zweiten Nitridabscheidung stammende Nitrid aus den Kontaktlöchern des Isolationsringes entfernt.

Schließlich erfolgt eine Abscheidung von Metall, das durch eine elfte Fototechnik für den Anschluß der vorher freigeätzten Kontaktlöcher und die Verdrahtung strukturiert wird.

In die anschließend abgeschiedene Passivierungsschicht zum Schutz der Systemoberfläche werden in einer zwölften Fototechnik Fenster für die äußeren Chipanschlüsse geätzt.

3. Verfahren nach Anspruch 2, d a d u r c h g e - k e n n z e i c h n e t , daß als Dotierstoffe bei der ersten und zweiten Diffusion Phosphor oder ein anderes geeignetes Element der Gruppe V verwendet wird.

4. Verfahren nach Anspruch 2 und/oder 3, d a - d u r c h g e k e n n z e i c h n e t , daß die erste, zweite, dritte und vierte Implantation mit Bor oder einem anderen geeigneten Element der Gruppe III erfolgt.

5. Verfahren nach mindestens einem der Ansprüche 2 bis 4, d a d u r c h   g e k e n n z e i c h n e t , daß die fünfte Implantation mit Arsen oder einem anderen geeigneten Element der Gruppe V erfolgt.

6. Verfahren nach mindestens einem der Ansprüche 2 bis 5, d a d u r c h   g e k e n n z e i c h n e t , daß die zweite Siliciumoxidschicht, die Tunneloxidschicht, eine Schichtdicke von 2 nm bis 4 nm, insbesondere eine Schichtdicke von 3 nm aufweist.

7. Verfahren nach mindestens einem der Ansprüche 2 bis 6, d a d u r c h   g e k e n n z e i c h n e t , daß die Schichtdicke der zweiten Siliciumnitridschicht 40 nm bis 60 nm, insbesondere 50 nm beträgt.

8. Verfahren nach mindestens einem der Ansprüche 2 bis 7, d a d u r c h   g e k e n n z e i c h n e t , daß die dritte Siliciumoxidschicht eine Stärke von 70 nm bis 150 nm, insbesondere von 120 nm besitzt.

9. Verfahren nach mindestens einem der Ansprüche 2 bis 8, d a d u r c h   g e k e n n z e i c h n e t , daß die Buriedkontakte aus Polysilicium bestehen.

10. Verfahren nach mindestens einem der Ansprüche 2 bis 9, d a d u r c h   g e k e n n z e i c h n e t , daß die Metallkontakte aus Aluminium mit einem gewissen Anteil an Silicium bestehen.

0019886

1/3

FIG1

FIG 2

FIG3

FIG4

FIG5

FIG6

FIG7

## FIG8

## FIG9

**Europäisches Patentamt**

# EUROPÄISCHER RECHERCHENBERICHT

0019886

Nummer der Anmeldung

EP 80 10 2900

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | <u>FR - A - 2 394 144</u> (FUJITSU)<br><br>* Seite 3, Zeile 6 - Seite 4, Zeile 32; Seite 7, Zeile 20 - Seite 13, Zeile 15; Figuren 3-11 *<br><br>& DE - A - 2 823 854<br>-- | 1,2,4 |
| | <u>DE - A - 2 450 230</u> (IBM)<br><br>* Seite 3, Abschnitt 4 - Seite 11. Abschnitt 2; Figur 1A-1K *<br>-- | 1,2 |
| | <u>US - A - 4 052 229</u> (INTEL)<br><br>* Zusammenfassung; Spalte 2, Zeile 30 - Spalte 4, Zeile 15; Figuren 1-6 *<br><br>& DE - A - 2 728 167<br>-- | 1-4 |
| | TECHNICAL DIGEST 1977 - INTERNATIONAL ELECTRON DEVICES MEETING, Dezember 5,6 & 7, 1977, Washington DC; IEEE<br>NEW YORK (US)<br>S. FUNKUNAGA: "FA-CMOS process for low power PROM with low avalanche injection voltage", Seiten 291-293<br><br>* Zusammenfassung; Seite 291, Spalte 2, Abschnitt 4 - Seite 292, Spalte 1, Abschnitt 4; Figur 1 *<br>-- | 1-5 |
| | <u>US - A - 4 011 653</u> (TOSHIBA)<br><br>* Zusammenfassung; Spalte 3, Zeile 12 - Spalte 6, Zeile 13, Figuren 1A-2B *<br><br>& DE - A - 2 241 472 | 1,2 |

./..

**KLASSIFIKATION DER ANMELDUNG** (Int Cl.)

H 01 L 27/08
G 11 C 11/34

**RECHERCHIERTE SACHGEBIETE** (Int. Cl.)

H 01 L 27/08
G 11 C 11/34

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie. übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 05.09.1980 | CHOMENTOWSKI |

EPA form 1503.1  06.78

Europäisches
Patentamt

# EUROPÄISCHER RECHERCHENBERICHT

| EINSCHLÄGIGE DOKUMENTE | | | KLASSIFIKATION DER ANMELDUNG (Int.Cl. 3) |
|---|---|---|---|
| Kategorie | Kennzeichnung des Dokuments mit Angabe, soweit erforderlich, der maßgeblichen Teile | betrifft Anspruch | |
| | US - A - 3 590 272 (WESTINGHOUSE ELECTRIC CO.) <br><br> * Zusammenfassung; Spalte 2, Zeile 43 - Spalte 4, Zeile 61; Figur 1 * | 1,6-8 | |
| | FUNKSCHAU, vol. 51, no. 8, 12 avril 1979 MUNCHEN (DE) H. SCHAUMBURG: "Lithografietechniken für höchstintegrierte Schaltungen", Seiten 431-434 <br><br> * Bild 2; Tabelle 1 * | 1,9,10 | RECHERCHIERTE SACHGEBIETE (Int. Cl. 3) |

EPA Form 1503.2  06.78